# EUROPEAN PATENT APPLICATION

(11) **EP 4 808 326 A1**
(43) Date of publication of application: **16.09.2026**
(21) Application number: 25219087.1
(22) Date of filing: 27.11.2025
(51) Int. Cl.: H10K 59/38

(54) **COLOR CONVERSION SUBSTRATE, METHOD OF MANUFACTURING COLOR CONVERSION SUBSTRATE, AND ELECTRONIC DEVICE**

(30) Priority: 14.03.2025 KR 20250033251
(71) Applicant: Samsung Display Co., Ltd., Yongin-si, Gyeonggi-do 17113 (KR)
(72) Inventor: KIM, Jongsung, 17113 Yongin-si (KR); MIN, Honggi, 17113 Yongin-si (KR); SEO, Jinwon, 17113 Yongin-si (KR); LEE, Hansol, 17113 Yongin-si (KR); LEE, Hee Jung, 17113 Yongin-si (KR)
(74) Representative: Marks & Clerk LLP

(57) **Abstract**

A color conversion substrate includes a base layer including first to third emission areas (EA1, EA2, EA3) and a non-emission area (NEA), a bank (BK) provided on the base layer (BS2) and defining first to third color conversion openings (CO1, CO2, CO3) respectively corresponding to the first to third emission areas and a spacer opening (SO) provided in the non-emission area, a color conversion layer (CCL) provided in the first to third color conversion openings, and a spacer (SPC) provided in the spacer opening and including substantially the same material as the color conversion layer. Each of the bank and the spacer includes a first surface opposite to (e.g., facing) the base layer and a second surface opposite to the first surface. The second surface of the spacer is convex in a direction opposite to a direction toward the base layer from the second surface of the bank.

## Description

### BACKGROUND

### 1. Field

One or more embodiments of the present disclosure relate to a color conversion substrate, a method of manufacturing a color conversion substrate, and an electronic device including the color conversion substrate. For example, one or more embodiments of the present disclosure relate to a color conversion substrate for a display device, a method of manufacturing the color conversion substrate, and an electronic device including the color conversion substrate.

### 2. Description of the Related Art

Flat panel display devices are replacing cathode ray tube display devices due to their lightweight and thin characteristics. Examples of the flat panel display devices include liquid crystal display devices and organic light emitting diode display devices.

Organic light emitting display devices including organic light emitting elements and a color conversion layer have been studied. The color conversion layer may convert the wavelength of light provided from the light emitting elements. Therefore, the color conversion layer may emit light having a different color from the incident light.

### SUMMARY

One or more aspects of embodiments of the present disclosure are directed toward a color conversion substrate that can be produced with reduced manufacturing cost and manufacturing time.

One or more aspects of embodiments of the present disclosure are directed toward a method of manufacturing a color conversion substrate with reduced manufacturing cost and manufacturing time.

One or more aspects of embodiments of the present disclosure are directed toward an electronic device including the color conversion substrate.

Additional aspects of embodiments will be set forth in part in the description which follows, and, in part, will be apparent from the description, or may be learned by practice of the presented embodiments of the disclosure.

A color conversion substrate according to one or more embodiments includes a base layer including a first emission area, a second emission area, and a third emission area that are spaced and/or apart (e.g., spaced apart or separated) from each other in plan view and a non-emission area around (e.g., surrounding) each of the first to third emission areas in plan view, a bank disposed or provided on the base layer and defining a first color conversion opening, a second color conversion opening, and a third color conversion opening respectively corresponding to the first to third emission areas and a spacer opening located or provided in the non-emission area, a color conversion layer disposed or provided in the first to third color conversion openings, and a spacer disposed or provided in the spacer opening and including substantially the same material as the color conversion layer. Each of the bank and the spacer includes a first surface opposite to (e.g., facing) the base layer and a second surface opposite to the first surface. The second surface of the spacer is convex in a direction opposite to a direction toward the base layer from the second surface of the bank.

In one or more embodiments, the color conversion layer may include a first color conversion portion disposed or provided in the first color conversion opening and including first color conversion particles that convert blue light into red light, a second color conversion portion disposed or provided in the second color conversion opening and including second color conversion particles that convert blue light into green light, and a light transmission portion disposed or provided in the third color conversion opening and transmitting blue light. The spacer may include substantially the same material as one selected from among the first color conversion portion, the second color conversion portion, and the light transmission portion.

In one or more embodiments, the spacer may include substantially the same material as the light transmission portion.

In one or more embodiments, in plan view, the light transmission portion and the spacer may be located or provided in a first direction from the first color conversion portion and the second color conversion portion. In plan view, the first color conversion portion and the second color conversion portion may be located or provided on a first virtual straight line extending in a second direction substantially normal (e.g., perpendicular) to the first direction. In plan view, the light transmission portion and the spacer may be located or provided on a second virtual straight line extending in the second direction and located or provided in the first direction from the first virtual straight line.

In one or more embodiments, in plan view, a center point of the first color conversion portion and a center point of the second color conversion portion may be located or provided on the first virtual straight line. In plan view, a center point of the light transmission portion and a center point of the spacer may be located or provided on the second virtual straight line.

In one or more embodiments, in plan view, a width of the spacer in the first direction may be less than or equal to a width of the light transmission portion in the first direction.

In one or more embodiments, the color conversion substrate may further include a color filter layer disposed or provided between the base layer and the color conversion layer. The color filter layer may include a first color filter overlapping the first emission area and selectively transmitting red light, a second color filter overlapping the second emission area and selectively transmitting green light, and a third color filter overlapping the third emission area and selectively transmitting blue light.

In one or more embodiments, each of the first color conversion portion, the second color conversion portion, and the light transmission portion may include a first surface opposite to (e.g., facing) the base layer and a second surface opposite to the first surface. The second surface of each of the first color conversion portion, the second color conversion portion, and the light transmission portion may be concave in a direction toward the base layer from the second surface of the bank.

In one or more embodiments, a thickness of the spacer may be greater than each of a thickness of the bank and a thickness of the color conversion layer.

In one or more embodiments, the first surface of the bank and the first surface of the spacer may be coplanar with each other.

A method of manufacturing a color conversion substrate according to one or more embodiments includes forming or providing a bank on a base layer and ejecting an ink to form or provide a color conversion layer. The base layer includes a first emission area, a second emission area, and a third emission area that are spaced and/or apart (e.g., spaced apart or separated) from each other in plan view and a non-emission area around (e.g., surrounding) each of the first to third emission areas in plan view. The bank defines a first color conversion opening, a second color conversion opening, and a third color conversion opening respectively corresponding to the first to third emission areas and a spacer opening located or provided in the non-emission area. The ink is ejected into the first to third color conversion openings and the spacer opening to form or provide the color conversion layer in the first to third color conversion openings and the spacer in the spacer opening. Each of the bank and the spacer includes a first surface opposite to (e.g., facing) the base layer and a second surface opposite to the first surface. The second surface of the spacer is convex in a direction opposite to a direction toward the base layer from the second surface of the bank.

In one or more embodiments, the forming or providing of the color conversion layer and the spacer may include ejecting a first ink including first color conversion particles that convert blue light into red light into the first color conversion opening to form or provide a first color conversion portion, ejecting a second ink including second color conversion particles that convert blue light into green light into the second color conversion opening to form or provide a second color conversion portion, and ejecting a third ink into the third conversion opening to form or provide a light transmission portion. The spacer may be concurrently (e.g., simultaneously) formed or provided with one selected from among the first color conversion portion, the second color conversion portion, and the light transmission portion.

In one or more embodiments, the spacer may be formed or provided by ejecting the third ink into the spacer opening concurrently (e.g., simultaneously) with the forming or providing of the light transmission portion.

In one or more embodiments, in plan view, the light transmission portion and the spacer may be located or provided in a first direction from the first color conversion portion and the second color conversion portion. In plan view, the first color conversion portion and the second color conversion portion may be located or provided on a first virtual straight line extending in a second direction substantially normal (e.g., perpendicular) to the first direction. In plan view, the light transmission portion and the spacer may be located or provided on a second virtual straight line extending in the second direction and located or provided in the first direction from the first virtual straight line.

In one or more embodiments, in the forming or providing of the color conversion layer and the spacer, the ink may be ejected from one or more of a plurality of nozzles arranged in the first direction while moving the base layer and the bank in the second direction.

In one or more embodiments, in the forming or providing of the color conversion layer and the spacer, the number of nozzles among the plurality of nozzles that eject the third ink into the spacer opening to form or provide the spacer may be less than or equal to the number of nozzles among the plurality of nozzles that eject the third ink into the third color conversion opening to form or provide the light transmission portion.

In one or more embodiments, a spacing distance between the light transmission portion and the spacer in the second direction may be an integer multiple of a droplet pitch of the ink in the second direction.

In one or more embodiments, the number of reciprocating movements of the base layer and the bank in the second direction to form or provide the spacer may be less than or equal to the number of reciprocating movements of the base layer and the bank in the second direction to form or provide the light transmission portion.

In one or more embodiments, a thickness of the spacer may be greater than each of a thickness of the bank and a thickness of the color conversion layer.

An electronic device according to one or more embodiments includes a display device and a processor configured or provided to transmit an image data signal and an input control signal to the display device. The display device includes an array substrate and a color conversion substrate disposed or provided on the array substrate. The array substrate includes a first emission area, a second emission area, and a third emission area that are spaced and/or apart (e.g., spaced apart or separated) from each other in plan view and a non-emission area around (e.g., surrounding) each of the first to third emission areas in plan view. The array substrate includes a first light emitting element, a second light emitting element, and a third light emitting element respectively disposed or provided in the first to third emission areas. The color conversion substrate includes a base layer, a bank disposed or provided on the base layer and defining a first color conversion opening, a second color conversion opening, and a third color conversion opening respectively corresponding to the first to third emission areas and a spacer opening located or provided in the non-emission area, a color conversion layer disposed or provided in the first to third color conversion openings, and a spacer disposed or provided in the spacer opening and including substantially the same material as the color conversion layer. Each of the bank and the spacer includes a first surface opposite to (e.g., facing) the base layer and a second surface opposite to the first surface. The second surface of the spacer is convex in a direction opposite to a direction toward the base layer from the second surface of the bank.

At least some of the above and other features of the invention are set out in the claims.

According to one or more embodiments, the color conversion substrate includes the color conversion layer and the spacer. The spacer is substantially concurrently (e.g., simultaneously) formed or provided with the color conversion layer in an inkjet printing process to form or provide the color conversion layer. Therefore, a process (e.g., a coating process and a photolithography process) to form or provide the spacer may not be provided. In one or more embodiments, it may not be necessary or desired to utilize additional nozzles to concurrently (e.g., simultaneously) form or provide the spacer with the color conversion layer, even compared to a case in which only the color conversion layer is formed or provided in the third inkjet printing process. Accordingly, even if (e.g., when) the number of defective nozzles increases due to a prolonged process, an increase in the process time of the third inkjet printing process may be minimized or reduced. Therefore, the manufacturing time and manufacturing cost of the color conversion substrate may be reduced.

However, the aspects, effects, and/or embodiments of the present disclosure are not restricted to the one set forth herein. The above and other aspects, effects, and/or embodiments of the present disclosure will become more apparent to one of daily skill in the art to which the present disclosure pertains by referencing the claims.

### BRIEF DESCRIPTION OF THE DRAWINGS

The accompanying drawings, together with the specification, illustrate embodiments of the subject matter of the present disclosure, and, together with the description, serve to explain principles of embodiments of the subject matter of the present disclosure.
FIG. 1 is a perspective view illustrating a display device according to one or more embodiments.
FIG. 2 is a cross-sectional view taken along the line I-I' of FIG. 1.
FIGS. 3 and 4 are plan views illustrating an example of the display device of FIG. 1.
FIG. 5 is a cross-sectional view taken along the line II-II' and the line III-III' of FIG. 4.
FIGS. 6-10 are drawings illustrating a method of manufacturing a color conversion substrate according to one or more embodiments.
FIG. 11 is a block diagram illustrating an electronic device according to one or more embodiments.
FIG. 12 is a schematic diagram illustrating electronic devices according to one or more embodiments.

### DETAILED DESCRIPTION

The subject matter of the present disclosure will be described more fully hereinafter with reference to the accompanying drawings, in which embodiments of the present disclosure are shown. As those skilled in the art would realize, the described embodiments may be modified in one or more suitable different ways, all without departing from the scope of the present disclosure. The drawings and description are to be regarded as illustrative in nature and not restrictive. Like reference numerals designate like elements throughout the attached drawings and the written description, and duplicative descriptions thereof may not be provided in the specification.

In the drawings, the sizes and relative sizes of layers and regions may be exaggerated for clarity.

In the present disclosure, one or more suitable modifications may be made, one or more suitable forms may be used, and certain embodiments will be illustrated in the drawings and described in more detail. However, this is not intended to limit the embodiments of the present disclosure to a specific form as disclosed, and it will be understood that all changes, equivalents, or substitutes which fall in the technical scope of the disclosure should be included.

The utilization of "may" if (e.g., when) describing embodiments of the present disclosure refers to "one or more embodiments of the present disclosure."

In the context of the present application and unless otherwise defined, the terms "use," "using," and "used" may be considered synonymous with the terms "utilize," "utilizing," and "utilized," respectively.

It will be understood that, although the terms "first," "second," "third," and/or the like may be used herein to describe one or more suitable elements, these elements should not be limited by these terms. These terms are used to distinguish one element from another. Thus, a first element as described herein may be termed a second element without departing from the scope of the present disclosure.

As used herein, the term "and/or" includes any and all combinations of one or more of the associated listed items.

Throughout the present disclosure, the expressions, such as "at least one of," "one of," and "selected from," if (e.g., when) preceding a list of elements, modify the entire list of elements and do not modify the individual elements of the list. For example, "at least one of a, b, or c," "at least one selected from among a, b, and c," "at least one selected from among a to c," and/or the like indicates only a, only b, only c, both (e.g., simultaneously) a and b, both (e.g., simultaneously) a and c, both (e.g., simultaneously) b and c, all of a, b, and c, or variations thereof.

It will be understood that if (e.g., when) an element, such as a layer, a film, a region, or a substrate, is referred to as being "on" or "above" another element, it may be directly on the other element or intervening elements may also be present therebetween. In contrast, if (e.g., when) an element is referred to as being "directly on" or "directly above" another element, there are no intervening elements present therebetween.

It will be understood that if (e.g., when) an element is referred to as being "connected" or "coupled" to another element, it may be directly connected or coupled to the other element or intervening element(s) may be present therebetween. In contrast, if (e.g., when) an element is referred to as being "directly connected" or "directly coupled" to another element, there are no intervening elements present therebetween.

Other words used to describe the relationship between elements should be interpreted in a like fashion (e.g., "between" versus "directly between," "adjacent" versus "directly adjacent," and/or the like).

The terminology used herein is for the purpose of describing certain example embodiments only and is not intended to be limiting of the scope of the present disclosure.

As used herein, the singular forms "a," "an," and "the" are intended to include the plural forms as well, unless the context clearly indicates otherwise.

It will be further understood that the terms "has," "includes," "having," and/or "including," if (e.g., when) used in the present disclosure, specify the presence of stated features, integers, steps, operations, elements, and/or components, but do not preclude the presence or addition of one or more other features, integers, steps, operations, elements, components, and/or groups thereof. For example, it should be understood that the term "comprise(s)/comprising," "include(s)/including," or "have/has/having" specifies the presence of stated features, integers, steps, operations, elements, and/or components, but do not preclude the presence or addition of one or more other features, integers, steps, operations, elements, components, and/or groups thereof. Also, the terms "comprise(s)/comprising," "include(s)/including," "have/has/having," or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the terms "substantially," "about," or similar terms are used as terms of approximation and not as terms of degree and are intended to account for the inherent deviations in measured or calculated values that would be recognized by those of ordinary skill in the art. "About" as used herein is inclusive of the stated value and refers to as being within an acceptable range of deviation for the particular value as determined by one of ordinary skill in the art, considering the measurement in question and the error associated with measurement of the particular quantity (e.g., the limitations of the measurement system). For example, "about" may refer to as being within one or more standard deviations or within ±30%, ±20%, ±10%, or ±5% of the stated value. Also, it should be understood that, even if (e.g., when) the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

Furthermore, relative terms, such as "lower," "bottom," "upper," and/or "top," may be used herein to describe one element's relationship to another element as illustrated in the drawings. It will be understood that relative terms are intended to encompass different orientations of the device in addition to the orientation depicted in the drawings. For example, if (e.g., when) the device in one of the drawings is turned over, elements described as being on the "lower" side of other elements may then be oriented on "upper" sides of the other elements. The term "lower" may therefore encompass both an orientation of "lower" and "upper," depending on the orientation of the drawing. Similarly, if (e.g., when) the device in one of the drawings is turned over, elements described as "below" or "beneath" other elements may then be oriented "above" the other elements. The terms "below" or "beneath" may, therefore, encompass both an orientation of above and below.

In the context of the present disclosure and unless otherwise defined, plan view is an orthographic projection of a three-dimensional object from the position of a horizontal plane that intersects the object. For example, it is a top-down view, showing the layout and spatial relationships of one or more elements within the object or structure. A plan view based on a z-axis (thickness) direction refers to a top-down view of the object, as if (e.g., when) looking directly down onto the surface from above. In this context, the z-axis direction is perpendicular or normal to the horizontal plane defined by x-axis and y-axis directions.

Unless otherwise defined, all terms (including technical and scientific terms) used herein have substantially the same meaning as generally understood by one of ordinary skill in the art to which the present disclosure belongs. It will be further understood that terms, such as those defined in generally used dictionaries, should be interpreted as having a meaning that is consistent with their meaning in the context of the relevant art and will not be interpreted in an idealized or overly formal sense unless expressly so defined herein.

Hereinafter, one or more embodiments of the present disclosure will be described in more detail with reference to the accompanying drawings.

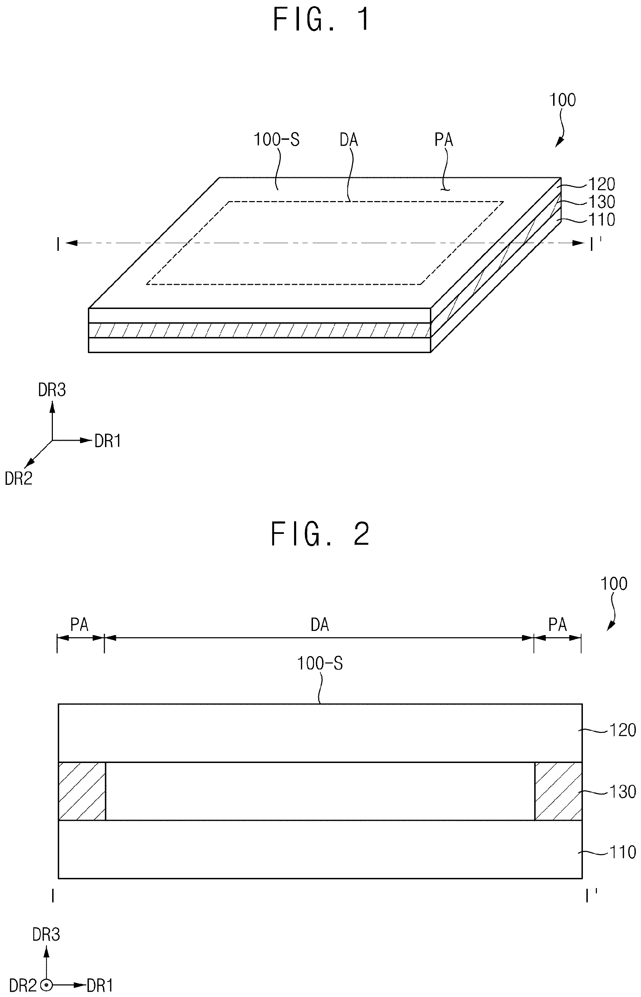

FIG. 1 is a perspective view illustrating a display device according to one or more embodiments. FIG. 2 is a cross-sectional view taken along the line I-I' of FIG. 1.

Referring to FIGS. 1 and 2, a display device 100 according to one or more embodiments may include an array substrate 110, a color conversion substrate 120, and a sealing member 130.

The display device 100 may include a display surface 100-S that displays an image. In one or more embodiments, the display surface 100-S may be substantially parallel to a plane defined by a first direction DR1 and a second direction DR2 crossing the first direction DR1. For example, the second direction DR2 may be substantially normal (e.g., perpendicular) to the first direction DR1. The display device 100 may display an image in a third direction DR3 through the display surface 100-S. The third direction DR3 may be substantially parallel to a normal direction of the display surface 100-S. The third direction DR3 may be substantially normal (e.g., perpendicular) to each of the first direction DR1 and the second direction DR2. The display surface 100-S may correspond to an upper surface (or a front surface) of the display device 100. In one or more embodiments, the display surface 100-S may be curved.

The display device 100 may include a display area DA that displays an image and a peripheral area PA located or provided around the display area DA. The peripheral area PA may be located or provided outside the display area DA. For example, the peripheral area PA may be around (e.g., surround) the display area DA in plan view.

The array substrate 110 may include a base layer, an insulating (e.g., electrically insulating) structure, elements to display an image, and/or the like. For example, the elements may include a driving element, a light emitting element, and/or the like.

The color conversion substrate 120 may be disposed or provided on the array substrate 110. The color conversion substrate 120 may be opposite to (e.g., face) the array substrate 110. The color conversion substrate 120 includes a color conversion layer that converts a wavelength of light emitted from the light emitting element. The array substrate 110 and the color conversion substrate 120 will be described in more detail herein.

The sealing member 130 may be disposed or provided in the peripheral area PA between the array substrate 110 and the color conversion substrate 120. The sealing member 130 may be disposed or provided along an edge of each of the array substrate 110 and the color conversion substrate 120 in the peripheral area PA and may be around (e.g., surround) the display area DA in plan view. The sealing member 130 may couple the array substrate 110 and the color conversion substrate 120. The sealing member 130 may include an organic material, such as an epoxy resin and/or the like, a frit, and/or the like.

The display device 100 may be an organic light emitting display device (e.g., OLED), a liquid crystal display device (e.g., LCD), a field emission display device (e.g., FED), a plasma display device (e.g., PDP), an electrophoretic display device (e.g., EPD), and/or the like. Hereinafter, for convenience of description, the display device 100 will be described in more detail by way of example as OLED.

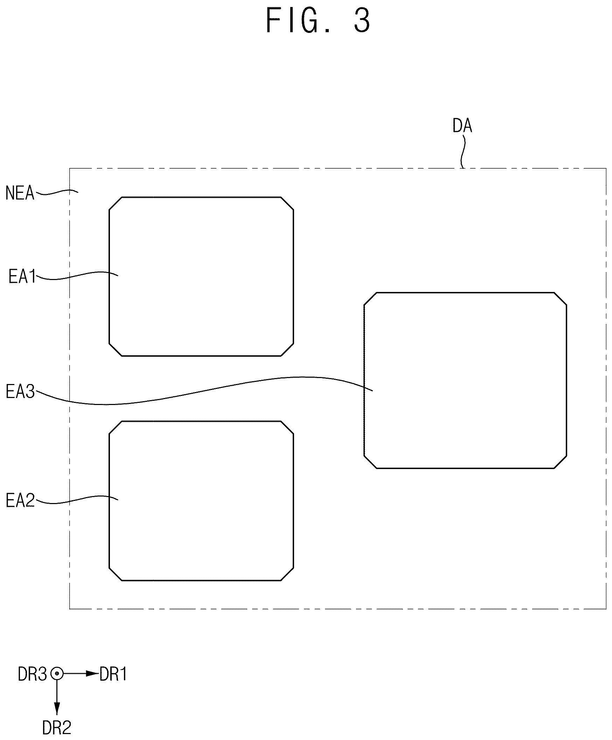

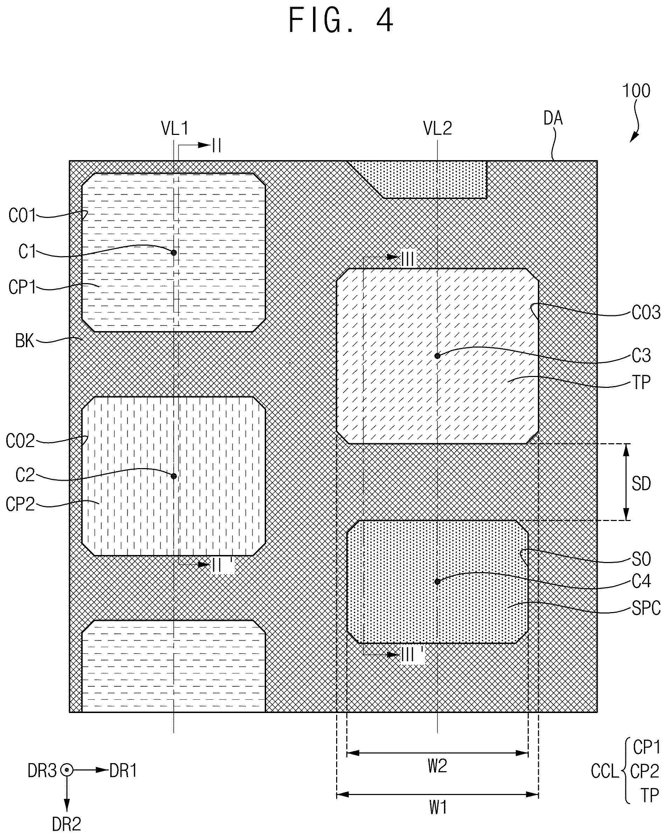

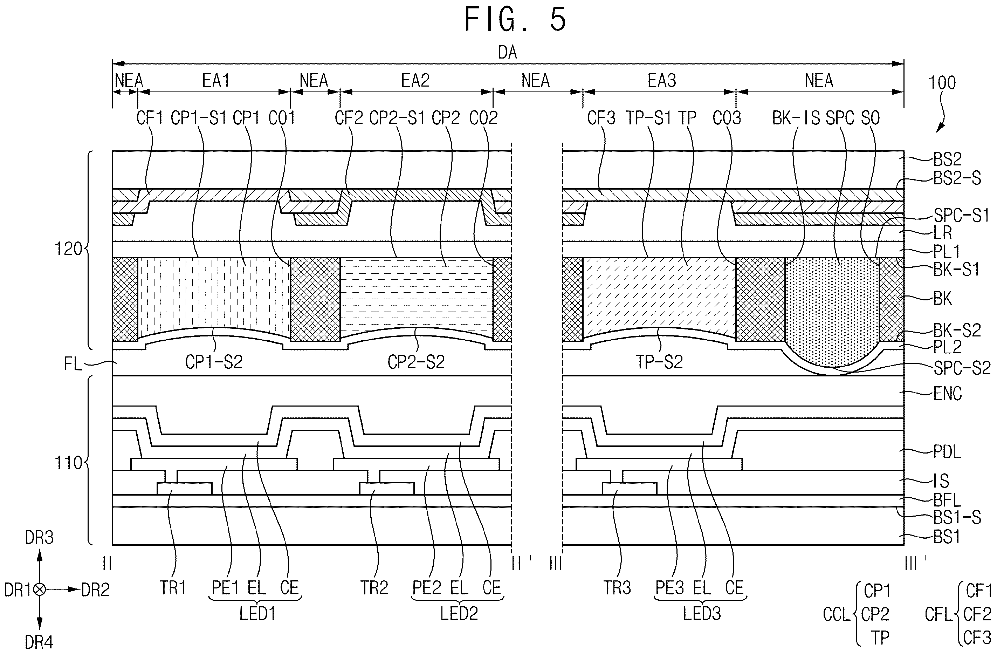

FIGS. 3 and 4 are plan views illustrating an example of the display device of FIG. 1. FIG. 5 is a cross-sectional view taken along the line II-II' and the line III-III' of FIG. 4.

For example, FIG. 3 is an enlarged plan view illustrating a portion of the display area DA of FIG. 1.

Referring to FIG. 3, in one or more embodiments, the display area DA may include a first emission area EA1, a second emission area EA2, a third emission area EA3, and a non-emission area NEA.

Each of the first to third emission areas EA1, EA2, and EA3 may be an area where light emitted from a light emitting element is emitted to the outside of the display device 100. For example, the first to third emission areas EA1, EA2, and EA3 may emit light of different colors. For example, the first emission area EA1 may emit red light, the second emission area EA2 may emit green light, and the third emission area EA3 may emit blue light, but this is an example and embodiments of the present disclosure are not limited thereto.

In plan view, the first to third emission areas EA1, EA2, and EA3 may be spaced and/or apart (e.g., spaced apart or separated) from each other. The first to third emission areas EA1, EA2, and EA3 adjacent to each other may form or provide one unit emission area. Although only one unit emission area is illustrated in FIG. 3, a plurality of unit emission areas may be repeatedly disposed or provided in the display area DA.

The non-emission area NEA may be located or provided between the first emission area EA1, the second emission area EA2, and the third emission area EA3. The non-emission area NEA may be around (e.g., surround) each of the first to third emission areas EA1, EA2, and EA3 in plan view. The non-emission area NEA may not emit light.

For convenience of description, FIG. 4 illustrates only one or more components included in the display device 100 around one unit emission area. For example, FIG. 4 illustrates a bank BK, a color conversion layer CCL, and a spacer SPC included in the color conversion substrate 120.

Referring to FIGS. 3 to 5, in one or more embodiments, the display device 100 may include the array substrate 110, the color conversion substrate 120, and a filling layer FL.

First, the array substrate 110 will be described herein in more detail. In one or more embodiments, the array substrate 110 may include a first base layer BS1, a buffer layer BFL, first to third driving elements TR1, TR2, and TR3, an insulating structure IS, a pixel defining layer PDL, a first light emitting element LED1, a second light emitting element LED2, a third light emitting element LED3, and an encapsulation layer ENC.

The first base layer BS1 may include the display area DA and the peripheral area PA (see FIG. 1). The first base layer BS1 may be an insulating (e.g., electrically insulating) substrate formed or composed of a transparent material or an opaque material. In one or more embodiments, the first base layer BS1 may include glass. In this case, the array substrate 110 may be a rigid array substrate. In one or more embodiments, the first base layer BS1 may include plastic. In this case, the array substrate 110 may be a flexible array substrate.

The first base layer BS1 may include a surface BS1-S opposite to (e.g., facing) the color conversion substrate 120.

The buffer layer BFL may be disposed or provided on the surface BS1-S of the first base layer BS1. The buffer layer BFL may be located or provided in the third direction DR3 from the first base layer BS1. The buffer layer BFL may prevent impurities, such as oxygen and/or moisture, from penetrating into the first to third driving elements TR1, TR2, and TR3 through the first base layer BS1 (or reduce a degree to or occurrence of which impurities, such as oxygen and/or moisture, penetrate into the first to third driving elements TR1, TR2, and TR3 through the first base layer BS1). The buffer layer BFL may include an inorganic material, such as a silicon compound, metal oxide, and/or the like. For example, the buffer layer BFL may include silicon oxide (e.g., SiOₓ, wherein 0 < x ≤ 2; e.g., SiO₂), silicon nitride (e.g., SiNₓ, wherein 0 < x ≤ 2; e.g., Si₃N₄), silicon oxynitride (e.g., SiOₓN_{y}, wherein 0 < x ≤ 2 and 0 ≤ y ≤ 2; e.g., SiON or Si₂N₂O), aluminium oxide (e.g., AlOₓ, wherein 0 < x ≤ 2; e.g., Al₂O₃), aluminium nitride (e.g., AlNₓ, wherein 0 < x ≤ 2; e.g., AIN), tantalum oxide (e.g., TaOₓ, wherein 0 < x ≤ 3; e.g., Ta₂O₅), hafnium oxide (e.g., HfOₓ, wherein 0 < x ≤ 2; e.g., HfO₂), zirconium oxide (e.g., ZrOₓ, wherein 0 < x ≤ 2; e.g., ZrO₂), titanium oxide (e.g., TiOₓ, wherein 0 < x ≤ 2; e.g., TiO₂), and/or the like. These materials may be used alone or in combination with each other. The buffer layer BFL may have a single layer structure or a multi-layer structure including a plurality of insulating (e.g., electrically insulating) layers.

The first to third driving elements TR1, TR2, and TR3 may be disposed or provided in the display area DA on the buffer layer BFL. Each of the first to third driving elements TR1, TR2, and TR3 may include at least one thin film transistor. An active layer of the thin film transistor may include an oxide semiconductor, a silicon semiconductor, an organic semiconductor, and/or the like. For example, the oxide semiconductor may include at least one selected from among oxides of indium (In), gallium (Ga), tin (Sn), zirconium (Zr), vanadium (V), hafnium (Hf), cadmium (Cd), germanium (Ge), chromium (Cr), titanium (Ti), and zinc (Zn). The silicon semiconductor may include an amorphous (e.g., non-crystalline) silicon, a polycrystalline silicon, and/or the like.

The insulating structure IS may cover the first to third driving elements TR1, TR2, and TR3. The insulating structure IS may include at least one inorganic insulating (e.g., electrically insulating) layer and/or at least one organic insulating (e.g., electrically insulating) layer.

First to third pixel electrodes PE1, PE2, and PE3 may be disposed or provided on the insulating structure IS. Each of the first to third pixel electrodes PE1, PE2, and PE3 may include a conductive (e.g., electrically conductive) material, such as a metal, an alloy, a conductive (e.g., electrically conductive) metal nitride, a conductive (e.g., electrically conductive) metal oxide, a transparent (e.g., substantially transparent) conductive (e.g., electrically conductive) material, and/or the like. Each of the first to third pixel electrodes PE1, PE2, and PE3 may have a single layer structure or a multi-layer structure including a plurality of conductive (e.g., electrically conductive) layers.

The first to third pixel electrodes PE1, PE2, and PE3 may be electrically connected to the first to third driving elements TR1, TR2, and TR3, respectively, through contact holes formed or provided in the insulating structure IS. The first to third pixel electrodes PE1, PE2, and PE3 may be spaced and/or apart (e.g., spaced apart or separated) from each other. For example, the first pixel electrode PE1 may be disposed or provided to correspond to the first emission area EA1, the second pixel electrode PE2 may be disposed or provided to correspond to the second emission area EA2, and the third pixel electrode PE3 may be disposed or provided to correspond to the third emission area EA3.

The pixel defining layer PDL may be disposed or provided on the insulating structure IS and the first to third pixel electrodes PE1, PE2, and PE3. The pixel defining layer PDL may include an organic insulating (e.g., electrically insulating) material. In one or more embodiments, the pixel defining layer PDL may further include a light blocking material, such as a black pigment, a dye, carbon black, and/or the like.

The pixel defining layer PDL may cover a peripheral portion of each of the first to third pixel electrodes PE1, PE2, and PE3. The pixel defining layer PDL may define a first pixel opening exposing a center of the first pixel electrode PE1, a second pixel opening exposing a center of the second pixel electrode PE2, and a third pixel opening exposing a center of the third pixel electrode PE3. For example, the first to third emission areas EA1, EA2, and EA3 may be defined by the first to third pixel openings, respectively.

An emission layer EL may be disposed or provided on the first to third pixel electrodes PE1, PE2, and PE3 exposed by the first to third pixel openings of the pixel defining layer PDL. In one or more embodiments, the emission layer EL may continuously extend across a plurality of pixels in the display area DA. In one or more embodiments, the emission layer EL may be separated from an emission layer of an adjacent pixel.

The emission layer EL may include an organic light emitting material. In one or more embodiments, the emission layer EL may generate blue light. However, embodiments of the present disclosure are not limited thereto, and the emission layer EL may generate red light or green light or may generate light having different colors depending on the pixel.

In one or more embodiments, functional layers, such as a hole injection layer, a hole transport layer, an electron transport layer, an electron injection layer, and/or the like, may be disposed or provided above and/or below the emission layer EL.

A common electrode CE may be disposed or provided on the emission layer EL. The common electrode CE may include a conductive (e.g., electrically conductive) material, such as a metal, an alloy, a conductive (e.g., electrically conductive) metal nitride, a conductive (e.g., electrically conductive) metal oxide, a transparent (e.g., substantially transparent) conductive (e.g., electrically conductive) material, and/or the like. The common electrode CE may have a single layer structure or a multi-layer structure including a plurality of conductive (e.g., electrically conductive) layers. In one or more embodiments, the common electrode CE may continuously extend over a plurality of pixels in the display area DA.

The first pixel electrode PE1, the emission layer EL, and the common electrode CE may form or provide the first light emitting element LED1, the second pixel electrode PE2, the emission layer EL, and the common electrode CE may form or provide the second light emitting element LED2, and the third pixel electrode PE3, the emission layer EL, and the common electrode CE may form or provide the third light emitting element LED3.

The first light emitting element LED1 may be disposed or provided in the first emission area EA1, the second light emitting element LED2 may be disposed or provided in the second emission area EA2, and the third light emitting element LED3 may be disposed or provided in the third emission area EA3.

The encapsulation layer ENC may be disposed or provided on the common electrode CE. In one or more embodiments, the encapsulation layer ENC may include at least one inorganic encapsulation layer and at least one organic encapsulation layer. For example, the encapsulation layer ENC may include a first inorganic encapsulation layer disposed or provided on the common electrode CE, an organic encapsulation layer disposed or provided on the first inorganic encapsulation layer, and a second inorganic encapsulation layer disposed or provided on the organic encapsulation layer.

Next, the color conversion substrate 120 will be described herein in more detail. The color conversion substrate 120 may be located or provided in the third direction DR3 from the array substrate 110. In one or more embodiments, the color conversion substrate 120 may include a second base layer BS2, a color filter layer CFL, a low refractive index layer LR, a first protective layer PL1, the bank BK, the color conversion layer CCL, the spacer SPC, and a second protective layer PL2.

The second base layer BS2 may include the display area DA and the peripheral area PA (see FIG. 1). The second base layer BS2 may be an insulating (e.g., electrically insulating) substrate formed or composed of a transparent material or an opaque material. In one or more embodiments, the second base layer BS2 may include glass. In this case, the color conversion substrate 120 may be a rigid color conversion substrate. In one or more embodiments, the second base layer BS2 may include plastic. In this case, the color conversion substrate 120 may be a flexible color conversion substrate.

The second base layer BS2 may include a surface BS2-S opposite to (e.g., facing) the array substrate 110.

The color filter layer CFL may be disposed or provided on the surface BS2-S of the second base layer BS2. The color filter layer CFL may be located or provided in a fourth direction DR4 opposite to the third direction DR3 from the second base layer BS2. The color filter layer CFL may be disposed or provided between the second base layer BS2 and the color conversion layer CCL.

In one or more embodiments, the color filter layer CFL may include a first color filter CF1, a second color filter CF2, and a third color filter CF3. For example, the first color filter CF1 may be a red color filter that selectively transmits red light, the second color filter CF2 may be a green color filter that selectively transmits green light, and the third color filter CF3 may be a blue color filter that selectively transmits blue light. However, this is an example and embodiments of the present disclosure are not limited thereto.

In one or more embodiments, at least a portion of the first color filter CF1 may overlap the first emission area EA1, at least a portion of the second color filter CF2 may overlap the second emission area EA2, and at least a portion of the third color filter CF3 may overlap the third emission area EA3.

In one or more embodiments, each of the first color filter CF1, the second color filter CF2, and the third color filter CF3 may be disposed or provided to further overlap the non-emission area NEA. For example, as illustrated in FIG. 5, the first color filter CF1 may overlap the first emission area EA1 and the non-emission area NEA and may not overlap the second emission area EA2 and the third emission area EA3. The second color filter CF2 may overlap the second emission area EA2 and the non-emission area NEA and may not overlap the first emission area EA1 and the third emission area EA3. The third color filter CF3 may overlap the third emission area EA3 and the non-emission area NEA and may not overlap the first emission area EA1 and the second emission area EA2. In this case, in the non-emission area NEA, portions of the first color filter CF1, the second color filter CF2, and the third color filter CF3 may overlap each other in the third direction DR3 which is a thickness direction. Accordingly, color mixing between adjacent first to third emission areas EA1, EA2, and EA3 may be prevented (or a degree or occurrence of color mixing between adjacent first to third emission areas EA1, EA2, and EA3 may be reduced).

The low refractive index layer LR may be disposed or provided on a surface of the color filter layer CFL. The low refractive index layer LR may be located or provided in the fourth direction DR4 from the color filter layer CFL. The low refractive index layer LR may be disposed or provided between the color filter layer CFL and the color conversion layer CCL. For example, the low refractive index layer LR may cover the color filter layer CFL on the surface BS2-S of the second base layer BS2.

The low refractive index layer LR may have a relatively low refractive index. For example, a refractive index of the low refractive index layer LR may be lower than a refractive index of the color conversion layer CCL. For example, the low refractive index layer LR may improve or enhance an emission efficiency of the display device 100 and may reduce external light reflection.

The low refractive index layer LR may include an organic material. For example, the low refractive index layer LR may include an organic polymer material including silicon. For example, a surface of the low refractive index layer LR opposite to (e.g., facing) the color conversion layer CCL may be substantially flat. For example, the low refractive index layer LR may also function as a planarization layer that smooths out a step difference caused by the color filter layer CFL. For another example, the low refractive index layer LR may have a substantially uniform thickness. In one or more embodiments, the low refractive index layer LR may not be provided.

The first protective layer PL1 may be disposed or provided on the surface of the low refractive index layer LR. The first protective layer PL1 may be located or provided in the fourth direction DR4 from the low refractive index layer LR. The first protective layer PL1 may be disposed or provided between the low refractive index layer LR and the color conversion layer CCL. For example, the first protective layer PL1 may cover the low refractive index layer LR on the surface BS2-S of the second base layer BS2.

In one or more embodiments, the first protective layer PL1 may include an inorganic material. For example, the first protective layer PL1 may include a silicon compound, a metal oxide, and/or the like. The first protective layer PL1 may block external impurities to prevent or reduce contamination of the color filter layer CFL and the low refractive index layer LR. For example, the first protective layer PL1 may have a substantially uniform thickness. In one or more embodiments, the first protective layer PL1 may not be provided.

The bank BK may be disposed or provided on a surface of the first protective layer PL1. The bank BK may be located or provided in the fourth direction DR4 from the first protective layer PL1. In one or more embodiments, the bank BK may include an organic material. In one or more embodiments, the bank BK may further include a light blocking material, such as a black pigment, a dye, carbon black, and/or the like.

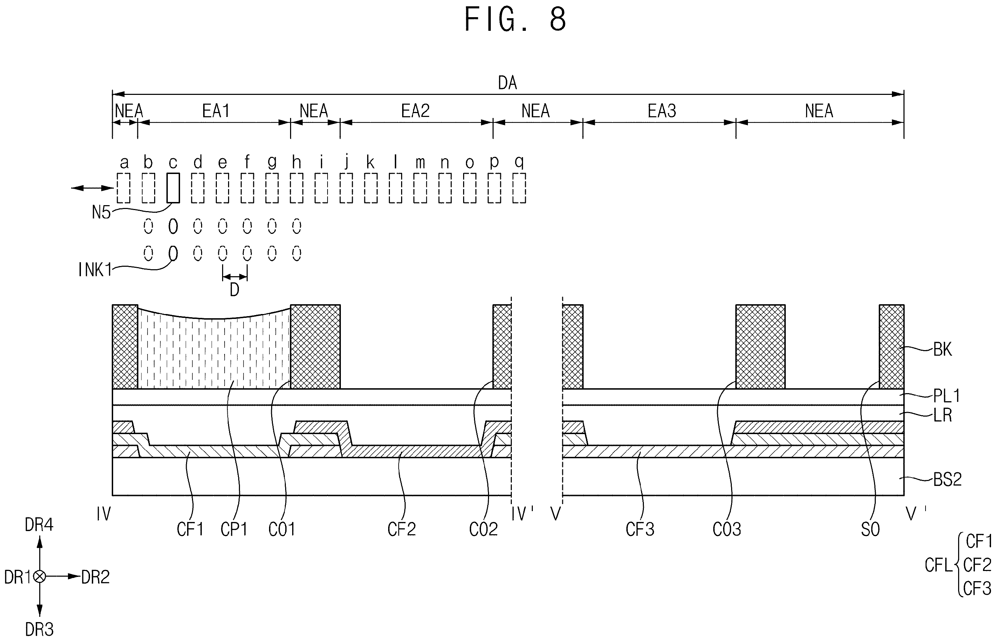

In one or more embodiments, as illustrated in FIGS. 4 and 5, the bank BK may overlap the non-emission area NEA and may not overlap the first to third emission areas EA1, EA2, and EA3. The bank BK defines a first color conversion opening CO1, a second color conversion opening CO2, a third color conversion opening CO3, and a spacer opening SO. The bank BK may provide a space capable of accommodating ink during a process to form or provide the color conversion layer CCL and the spacer SPC (see FIGS. 8 to 10).

The first to third color conversion openings CO1, CO2, and CO3 correspond to the first to third emission areas EA1, EA2, and EA3, respectively. The first color conversion opening CO1 may overlap the first emission area EA1, the second color conversion opening CO2 may overlap the second emission area EA2, and the third color conversion opening CO3 may overlap the third emission area EA3. The spacer opening SO is located or provided in the non-emission area NEA. The spacer opening SO may overlap a portion of the non-emission area NEA.

In one or more embodiments, the bank BK may further define dummy openings located or provided around the first to third color conversion openings CO1, CO2, and CO3 and the spacer opening SO. The dummy openings may be located or provided in the non-emission area NEA. The dummy openings may accommodate ink that is excessively or substantially provided (or ejected) during the process to form or provide the color conversion layer CCL and the spacer SPC, thereby preventing ink from being mixed (or reducing a degree to or occurrence of which ink is mixed) between the adjacent first to third color conversion openings CO1, CO2, and CO3.

The bank BK may include a first surface BK-S1 opposite to (e.g., facing) the second base layer BS2, a second surface BK-S2 opposite to the first surface BK-S1, and side surfaces BK-IS defining the first to third color conversion openings CO1, CO2, and CO3 and the spacer opening SO. The second surface BK-S2 may be opposite to (e.g., face) the array substrate 110. In one or more embodiments, the side surfaces BK-IS of the bank BK may have lyophilic property, and the second surface BK-S2 of the bank BK may have lyophobic property.

The color conversion layer CCL may be disposed or provided on the surface of the first protective layer PL1. The color conversion layer CCL may be located or provided in the fourth direction DR4 from the first protective layer PL1. The color conversion layer CCL is disposed or provided in the first to third color conversion openings CO1, CO2, and CO3 of the bank BK.

In one or more embodiments, the color conversion layer CCL may include a first color conversion portion CP1, a second color conversion portion CP2, and a light transmission portion TP. For example, the first color conversion portion CP1 may be disposed or provided in the first color conversion opening CO1, the second color conversion portion CP2 may be disposed or provided in the second color conversion opening CO2, and the light transmission portion TP may be disposed or provided in the third color conversion opening CO3.

The first color conversion portion CP1 may convert light (e.g., blue light) emitted from the first light emitting element LED1 into light of a first color (e.g., red light). The second color conversion portion CP2 may convert light (e.g., blue light) emitted from the second light emitting element LED2 into light of a second color (e.g., green light). The light transmission portion TP may transmit light (e.g., blue light) emitted from the third light emitting element LED3.

The first color conversion portion CP1 may include a first resin layer including an organic material having light transmitting property, and first color conversion particles dispersed in the first resin layer. In one or more embodiments, the first color conversion particles may convert incident blue light into red light. For example, the first color conversion particles may be red quantum dots that absorb incident blue light, shift a wavelength according to an energy transition, and emit red light. In one or more embodiments, the first color conversion portion CP1 may further include scatterers (e.g., light scatterers) dispersed in the first resin layer.

The second color conversion portion CP2 may include a second resin layer including an organic material having light transmitting property, and second color conversion particles dispersed in the second resin layer. In one or more embodiments, the second color conversion particles may convert incident blue light into green light. For example, the second color conversion particles may be green quantum dots that absorb incident blue light, shift a wavelength according to an energy transition, and emit green light. In one or more embodiments, the second color conversion portion CP2 may further include scatterers (e.g., light scatterers) dispersed in the second resin layer.

The light transmission portion TP may include a third resin layer including an organic material having light transmitting property. The light transmission portion TP may not include color conversion particles. In one or more embodiments, the light transmission portion TP may further include scatterers (e.g., light scatterers) dispersed in the third resin layer.

In one or more embodiments, an average thickness of the first color conversion portion CP1 in the third direction DR3 may be less than an average thickness of the bank BK. An average thickness of the second color conversion portion CP2 in the third direction DR3 may be less than the average thickness of the bank BK. An average thickness of the light transmission portion TP in the third direction DR3 may be less than the average thickness of the bank BK.

The first color conversion portion CP1 may include a first surface CP1-S1 opposite to (e.g., facing) the second base layer BS2 and a second surface CP1-S2 opposite to the first surface CP1-S1. The second surface CP1-S2 may be opposite to (e.g., face) the array substrate 110.

The second color conversion portion CP2 may include a first surface CP2-S1 opposite to (e.g., facing) the second base layer BS2 and a second surface CP2-S2 opposite to the first surface CP2-S1. The second surface CP2-S2 may be opposite to (e.g., face) the array substrate 110.

The light transmission portion TP may include a first surface TP-S1 opposite to (e.g., facing) the second base layer BS2 and a second surface TP-S2 opposite to the first surface TP-S1. The second surface TP-S2 may be opposite to (e.g., face) the array substrate 110.

In one or more embodiments, as illustrated in FIG. 5, the second surface CP1-S2 of the first color conversion portion CP1 may be concave in the third direction DR3, which is a direction toward the second base layer BS2, from the second surface BK-S2 of the adjacent bank BK. As described in one or more embodiments, because the side surfaces BK-IS of the bank BK may have lyophilic property and the second surface BK-S2 of the bank BK may have lyophobic property, if (e.g., when) an appropriate or suitable amount of ink is ejected into the first color conversion opening CO1 such that the average thickness of the first color conversion portion CP1 is less than the average thickness of the bank BK (see FIG. 8), the first color conversion portion CP1 may be formed or provided such that the second surface CP1-S2 is concave in the third direction DR3.

In one or more embodiments, the second surface CP2-S2 of the second color conversion portion CP2 may be concave in the third direction DR3 from the second surface BK-S2 of the adjacent bank BK. The second surface TP-S2 of the light transmission portion TP may be concave in the third direction DR3 from the second surface BK-S2 of the adjacent bank BK.

The spacer SPC may be disposed or provided on the surface of the first protective layer PL1. The spacer SPC may be located or provided in the fourth direction DR4 from the first protective layer PL1. The spacer SPC is disposed or provided in the spacer opening SO of the bank BK.

The spacer SPC includes substantially the same material as the color conversion layer CCL. The spacer SPC may include substantially the same material as one selected from among the first color conversion portion CP1, the second color conversion portion CP2, and the light transmission portion TP. The spacer SPC is formed or provided in substantially the same inkjet printing process as one selected from among the first color conversion portion CP1, the second color conversion portion CP2, and the light transmission portion TP.

In one or more embodiments, the spacer SPC may include substantially the same material as the light transmission portion TP and may be substantially concurrently (e.g., simultaneously) formed or provided with the light transmission portion TP in an inkjet printing process to form or provide the light transmission portion TP. For example, among a first ink to form or provide the first color conversion portion CP1, a second ink to form or provide the second color conversion portion CP2, and a third ink to form or provide the light transmission portion TP, the third ink may have a relatively high solid content (e.g., amount), so that (e.g., such that) the third ink may be suitable to form or provide the spacer SPC. However, this is an example and embodiments of the present disclosure are not limited thereto. In one or more embodiments, the spacer SPC may include substantially the same material as the first color conversion portion CP1 or the second color conversion portion CP2 and may be substantially concurrently (e.g., simultaneously) formed or provided with the first color conversion portion CP1 or the second color conversion portion CP2 in an inkjet printing process to form or provide the first color conversion portion CP1 or the second color conversion portion CP2.

The spacer SPC may maintain a gap between the array substrate 110 and the color conversion substrate 120. An average thickness of the spacer SPC in the third direction DR3 may be greater than an average thickness of the color conversion layer CCL and the average thickness of the bank BK. Herein, the average thickness of the color conversion layer CCL may be an average value of the average thickness of the first color conversion portion CP1, the average thickness of the second color conversion portion CP2, and the average thickness of the light transmission portion TP.

The spacer SPC may include a first surface SPC-S1 opposite to (e.g., facing) the second base layer BS2 and a second surface SPC-S2 opposite to the first side SPC-S1. The second surface SPC-S2 may be opposite to (e.g., face) the array substrate 110.

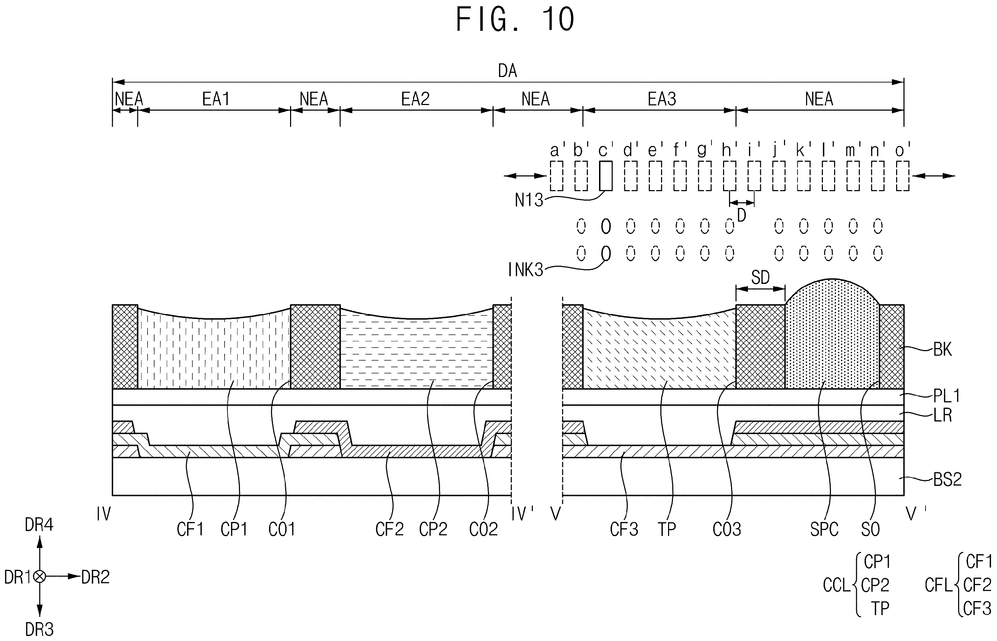

As illustrated in FIG. 5, the second surface SPC-S2 of the spacer SPC is convex in the fourth direction DR4, which is a direction opposite to the direction toward the second base layer BS2, from the second surface BK-S2 of the adjacent bank BK. For example, the spacer SPC may protrude by a certain (e.g., set or predetermined) distance in the fourth direction DR4 (a direction toward the array substrate 110) from the second surface BK-S2 of the bank BK. As described in one or more embodiments, because the side surfaces BK-IS of the bank BK may have lyophilic property and the second surface BK-S2 of the bank BK may have lyophobic property, if (e.g., when) an appropriate or suitable amount of ink is ejected into the spacer opening SO such that the average thickness of the spacer SPC is greater than the average thickness of the bank BK (see FIG. 10), the spacer SPC may be formed or provided such that the second surface SPC-S2 is convex in the fourth direction DR4.

In one or more embodiments, the first surface BK-S1 of the bank BK and the first surface SPC-S1 of the spacer SPC may contact substantially the same layer. For example, as illustrated in FIG. 5, the first surface BK-S1 of the bank BK and the first surface SPC-S1 of the spacer SPC may contact the first protective layer PL1. For another example, if (e.g., when) the first protective layer PL1 is not provided, the first surface BK-S1 of the bank BK and the first surface SPC-S1 of the spacer SPC may contact the low refractive index layer LR. For another example, if (e.g., when) the first protective layer PL1 and the low refractive index layer LR are not provided, the first surface BK-S1 of the bank BK and the first surface SPC-S1 of the spacer SPC may contact the color filter layer CFL. However, this is an example and embodiments of the present disclosure are not limited thereto.

In one or more embodiments, as illustrated in FIG. 5, the first surface BK-S1 of the bank BK and the first surface SPC-S1 of the spacer SPC may be coplanar with each other. For example, the first surface BK-S1 of the bank BK and the first surface SPC-S1 of the spacer SPC may be substantially flat. However, this is an example and embodiments of the present disclosure are not limited thereto.

The second protective layer PL2 may be disposed or provided on the second surface BK-S2 of the bank BK, the second surface CP1-S2 of the first color conversion portion CP1, the second surface CP2-S2 of the second color conversion portion CP2, the second surface TP-S2 of the light transmission portion TP, and the second surface SPC-S2 of the spacer SPC. The second protective layer PL2 may cover the second surface BK-S2 of the bank BK, the second surface CP1-S2 of the first color conversion portion CP1, the second surface CP2-S2 of the second color conversion portion CP2, the second surface TP-S2 of the light transmission portion TP, and the second surface SPC-S2 of the spacer SPC. The second protective layer PL2 may be located or provided in the fourth direction DR4 from the bank BK, the color conversion layer CCL, and the spacer SPC.

In one or more embodiments, the second protective layer PL2 may include an inorganic material. For example, the second protective layer PL2 may include a silicon compound, a metal oxide, and/or the like. The second protective layer PL2 may block external impurities to prevent or reduce contamination of the color conversion layer CCL. For example, the second protective layer PL2 may have a substantially uniform thickness. In one or more embodiments, the second protective layer PL2 may not be provided.

Hereinafter, with reference to FIG. 4, in one or more embodiments in which the spacer SPC includes substantially the same material as the light transmission portion TP and is substantially concurrently (e.g., simultaneously) formed or provided with the light transmission portion TP in an inkjet printing process to form or provide the light transmission portion TP, an example of an arrangement relationship in plan view between the first color conversion portion CP1, the second color conversion portion CP2, the light transmission portion TP, and the spacer SPC will be described in more detail.

In one or more embodiments, as illustrated in FIG. 4, in plan view, the first color conversion portion CP1 and the second color conversion portion CP2 may be disposed or provided in a line in the second direction DR2. In plan view, the first color conversion portion CP1 and the second color conversion portion CP2 may be located or provided on a first virtual straight line VL1 which extends in the second direction DR2. For example, in plan view, a center point C1 of the first color conversion portion CP1 and a center point C2 of the second color conversion portion CP2 may be located or provided on the first virtual straight line VL1.

In plan view, the light transmission portion TP and the spacer SPC may be located or provided in the first direction DR1 from the first color conversion portion CP1 and the second color conversion portion CP2.

In plan view, the light transmission portion TP and the spacer SPC may be disposed or provided in a line in the second direction DR2. In plan view, the light transmission portion TP and the spacer SPC may be located or provided on a second virtual straight line VL2 which extends in the second direction DR2 and is located or provided in the first direction DR1 from the first virtual straight line VL1. For example, in plan view, a center point C3 of the light transmission portion TP and a center point C4 of the spacer SPC may be located or provided on the second virtual straight line VL2.

In one or more embodiments, a width W2 of the spacer SPC in the first direction DR1 may be less than or equal to a width W1 of the light transmission portion TP in the first direction DR1.

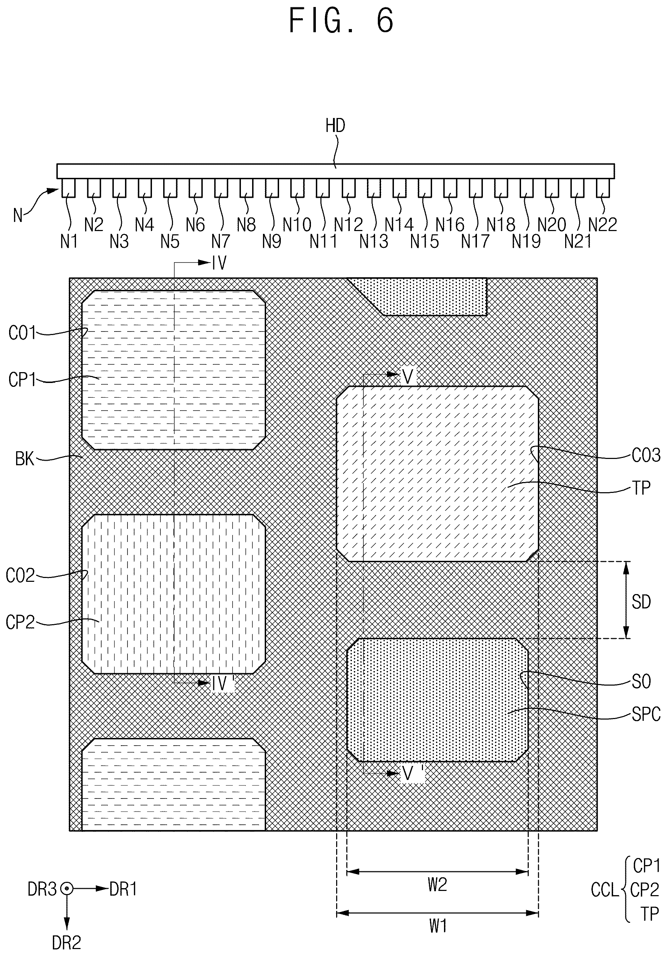

If (e.g., when) the spacer SPC and the light transmission portion TP substantially concurrently (e.g., simultaneously) formed or provided with each other in substantially the same inkjet printing process are arranged in a line in the second direction DR2, and the width W2 of the spacer SPC in the first direction DR1 is less than or equal to the width W1 of the light transmission portion TP in the first direction DR1, the number of nozzles, utilized to form or provide the spacer SPC and the light transmission portion TP, among nozzles N utilized in the inkjet printing process and disposed or provided in the first direction DR1 (see FIG. 6), may be minimized or reduced. For example, if (e.g., when) the spacer SPC and the light transmission portion TP substantially concurrently (e.g., simultaneously) formed or provided with each other in substantially the same inkjet printing process are arranged in a line in the second direction DR2, and the width W2 of the spacer SPC in the first direction DR1 is less than or equal to the width W1 of the light transmission portion TP in the first direction DR1, it may not be necessary or desired to utilize additional nozzles to concurrently (e.g., simultaneously) form or provide the spacer SPC with the light transmission portion TP, even compared to a case in which only the light transmission portion TP is formed or provided in one inkjet printing process. For example, all of the nozzles utilized to form or provide the spacer SPC may be nozzles utilized to form or provide the light transmission portion TP. Accordingly, even if (e.g., when) the number of defective nozzles (e.g., nozzles that become unusable due to malfunction) among the nozzles N increases due to a prolonged process, an increase in the process time of the inkjet printing process may be minimized or reduced. Accordingly, the manufacturing time and manufacturing cost of the color conversion substrate 120 may be reduced.

As illustrated in FIG. 4, the spacer SPC may be spaced and/or apart (e.g., spaced apart or separated) from the light transmission portion TP in the second direction DR2 by a certain (e.g., set or predetermined) spacing distance SD. In one or more embodiments, the spacing distance SD may be an integer multiple of a droplet pitch of the ink in the second direction DR2 in the inkjet printing process (see FIG. 10). This will be described in more detail herein with reference to FIGS. 6 to 10.

In one or more embodiments in which the spacer SPC includes substantially the same material as the first color conversion portion CP1 and is substantially concurrently (e.g., simultaneously) formed or provided with the first color conversion portion CP1 in an inkjet printing process to form or provide the first color conversion portion CP1, the first color conversion portion CP1 and the spacer SPC may be disposed or provided in a line in the second direction DR2 in plan view. In one or more embodiments in which the spacer SPC includes substantially the same material as the second color conversion portion CP2 and is substantially concurrently (e.g., simultaneously) formed or provided with the second color conversion portion CP2 in an inkjet printing process to form or provide the second color conversion portion CP2, the second color conversion portion CP2 and the spacer SPC may be disposed or provided in a line in the second direction DR2 in plan view.

The filling layer FL may be disposed or provided between the array substrate 110 and the color conversion substrate 120. For example, the filling layer FL may be disposed or provided between the encapsulation layer ENC and the second protective layer PL2. The filling layer FL may be disposed or provided on an inner side of the sealing member 130 (see FIG. 2). The filling layer FL may serve as a buffer against external pressure applied to the display device 100. For example, the filling layer FL may include an organic material having light transmitting property. In one or more embodiments, the filling layer FL may not be provided.

FIGS. 6 to 10 are drawings illustrating a method of manufacturing a color conversion substrate according to one or more embodiments.

Hereinafter, with reference to FIGS. 6 to 10, an example of a method of manufacturing the color conversion substrate 120 included in the display device 100 as described with reference to FIGS. 3 to 5 will be described in more detail. Hereinafter, descriptions overlapping with the description of the color conversion substrate 120 as described with reference to FIGS. 3 to 5 will not be provided or will be simplified.

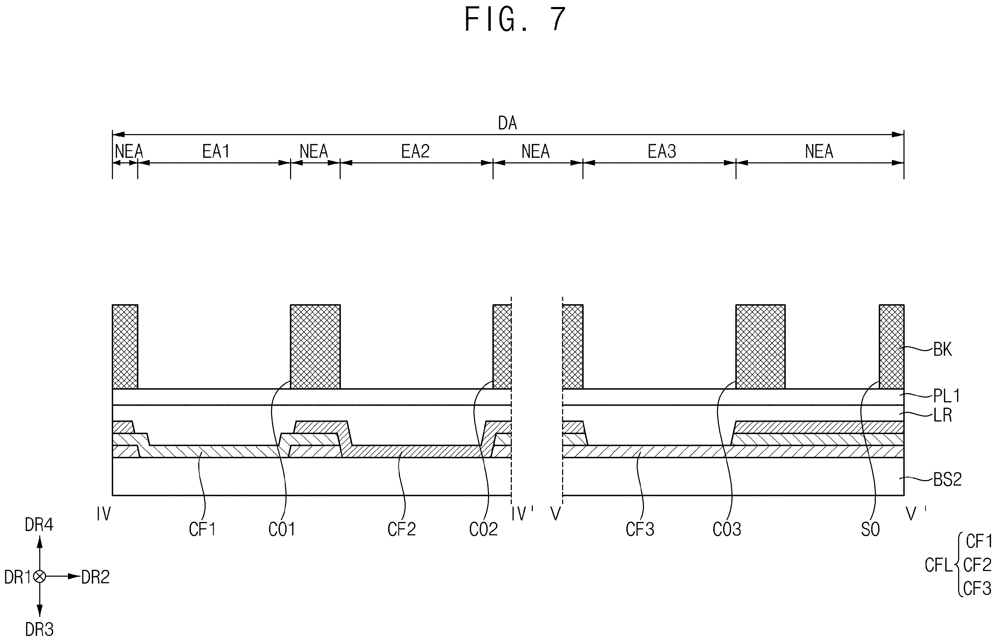

FIG. 6 may correspond to FIG. 4. FIG. 6 additionally schematically illustrates an inkjet head HD utilized in inkjet printing processes to form or provide the first color conversion portion CP1, the second color conversion portion CP2, the light transmission portion TP, and the spacer SPC disposed or provided in the unit emission area of FIG. 4. Each of FIGS. 7 to 10 may correspond to a cross-sectional view taken along the line IV-IV' and the line V-V' of FIG. 6.

Referring to FIGS. 6 and 7, the color filter layer CFL, the low refractive index layer LR, the first protective layer PL1, and the bank BK may be formed or provided on the second base layer BS2 including the first to third emission areas EA1, EA2, and EA3 and a non-emission area NEA.

The bank BK defines the first to third color conversion openings CO1, CO2, and CO3 and the spacer opening SO. In one or more embodiments, a photosensitive organic material may be applied on the first protective layer PL1 to form or provide an organic layer. The organic layer may be patterned by a photolithography process utilizing a photomask to form or provide the bank BK that defines the first to third color conversion openings CO1, CO2, and CO3 and the spacer opening SO.

Referring to FIGS. 6 and 8 to 10, ink is ejected into the first to third color conversion openings CO1, CO2, and CO3 and the spacer openings SO of the bank BK by an inkjet printing process to form or provide the color conversion layer CCL and the spacer SPC.

In one or more embodiments, the inkjet printing process may be performed utilizing an inkjet head HD including a plurality of nozzles N disposed or provided in the first direction DR1. FIG. 6 illustrates first to twenty-second nozzles N1-N22, which are one or more of the nozzles N.

As illustrated in FIGS. 6 and 8, a first ink INK1 may be ejected from one or more of the nozzles N into the first color conversion opening CO1 to form or provide the first color conversion portion CP1.

In one or more embodiments, a first inkjet printing process to form or provide the first color conversion portion CP1 may be performed while a position of the inkjet head HD is fixed and a stage on which a target substrate (e.g., a structure in which the bank BK and/or the like are formed or provided on the second base layer BS2) is mounted reciprocally moves in the second direction DR2. For example, while the target substrate is moving in the second direction DR2, the first ink INK1 may be ejected at certain (e.g., set or predetermined) frequency from one or more of the nozzles N disposed or provided in the first direction DR1. For example, in the example of FIG. 6, in the first inkjet printing process to form or provide the first color conversion portion CP1, second to eighth nozzles N2-N8 among the nozzles N may eject the first ink INK1, and the remaining nozzles may not eject the ink. FIG. 8 illustrates the fifth nozzle N5, representative of the second to eighth nozzles N2-N8, which corresponds to the line IV-IV'.

As illustrated in FIG. 8, during the first inkjet printing process, the position of the inkjet head HD may be fixed and the target substrate may be moved in the second direction DR2, so that (e.g., such that) a position a-q of the nozzle (e.g., the fifth nozzle N5) relative to the target substrate in the second direction DR2 may vary. Although FIG. 8 illustrates that the target substrate is fixed and the fifth nozzle N5 moves in the second direction DR2, in one or more embodiments, as described herein, the position of the fifth nozzle N5 may be fixed and the stage on which the target substrate is mounted may be moved in the second direction DR2.

During the first inkjet printing process, the second to eighth nozzles N2-N8 may eject the first ink INK1 if (e.g., when) they are at positions b-h which correspond to the first color conversion opening CO1, and may not eject the first ink INK1 if (e.g., when) they are at positions a and i-q which do not correspond to the first color conversion opening CO1. Herein, the positions b-h which correspond to the first color conversion opening CO1 may refer to the positions at which ink ejected from the nozzle may land in the first color conversion opening CO1.

Ink drops ejected from one nozzle (e.g., the fifth nozzle N5) at certain (e.g., set or predetermined) frequency may land on the target substrate (e.g., in the first color conversion opening CO1) at a uniform pitch D (hereinafter, "droplet pitch") in the second direction DR2. The droplet pitch D may be determined by the ink ejection frequency of the nozzle, the falling speed of the ink drops, a moving speed of the stage, and/or the like.

The first inkjet printing process may be performed while reciprocating the target substrate in the second direction DR2 until an appropriate or suitable amount of the first ink INK1 is ejected in the first color conversion opening CO1.

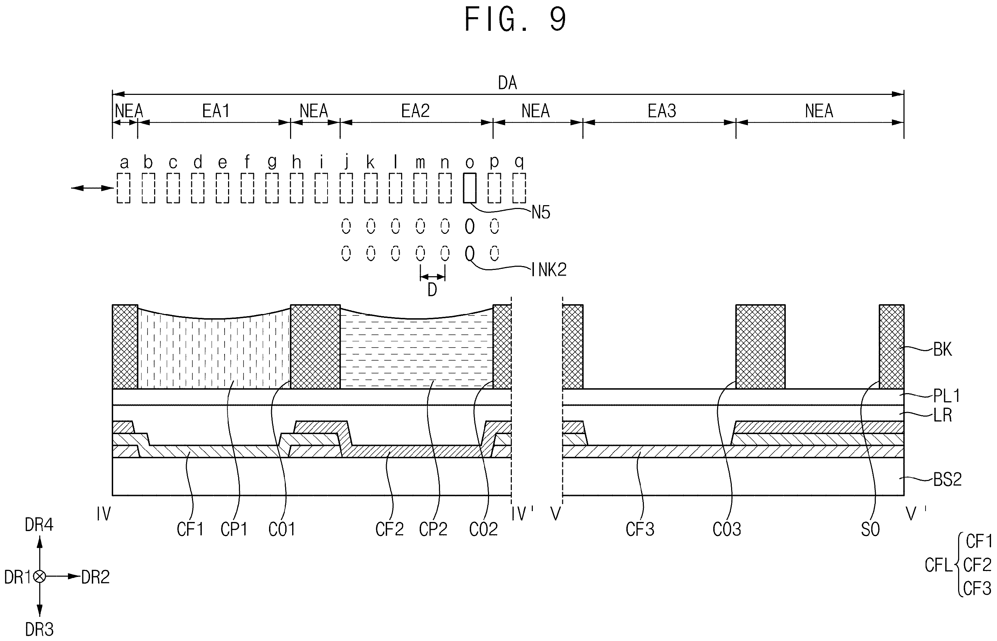

As illustrated in FIGS. 6 and 9, a second ink INK2 may be ejected into the second color conversion opening CO2 from one or more of the nozzles N to form or provide the second color conversion portion CP2.

In one or more embodiments, a second inkjet printing process to form or provide the second color conversion portion CP2 may be performed while the position of the inkjet head HD is fixed and the stage on which the target substrate is mounted reciprocally moves in the second direction DR2. For example, while the target substrate is moving in the second direction DR2, the second ink INK2 may be ejected at certain (e.g., set or predetermined) frequency from one or more of the nozzles N disposed or provided in the first direction DR1. For example, in the example of FIG. 6, in the second inkjet printing process to form or provide the second color conversion portion CP2, the second to eighth nozzles N2-N8 among the nozzles N may eject the second ink INK2, and the remaining nozzles may not eject the ink. FIG. 9 illustrates the fifth nozzle N5, representative of the second to eighth nozzles N2-N8, which corresponds to the line IV-IV'.

As illustrated in FIG. 9, during the second inkjet printing process, the position of the inkjet head HD may be fixed and the target substrate may be moved in the second direction DR2, so that (e.g., such that) a position a-q of the nozzle (e.g., the fifth nozzle N5) relative to the target substrate in the second direction DR2 may vary.

During the second inkjet printing process, the second to eighth nozzles N2-N8 may eject the second ink INK2 if (e.g., when) they are at positions j-p which correspond to the second color conversion opening CO2, and may not eject the second ink INK2 if (e.g., when) they are at positions q and a-i which do not correspond to the second color conversion opening CO2. Herein, the positions j-p which correspond to the second color conversion opening CO2 may refer to the positions at which ink ejected from the nozzle may land in the second color conversion opening CO2.

The second inkjet printing process may be performed while reciprocating the target substrate in the second direction DR2 until an appropriate or suitable amount of the second ink INK2 is ejected in the second color conversion opening CO2.

As illustrated in FIGS. 6 and 10, a third ink INK3 may be ejected into the third color conversion opening CO3 from one or more of the nozzles N to form or provide the light transmission portion TP and may be ejected into the spacer opening SO from one or more of the nozzles N to form or provide the spacer SPC. In one or more embodiments, the spacer SPC may be substantially concurrently (e.g., simultaneously) formed or provided with the light transmission portion TP in a third inkjet printing process to form or provide the light transmission portion TP.

In one or more embodiments, the third inkjet printing process to form or provide the light transmission portion TP and the spacer SPC may be performed while the position of the inkjet head HD is fixed and the stage on which the target substrate is mounted reciprocally moves in the second direction DR2. For example, while the target substrate is moving in the second direction DR2, the third ink INK3 may be ejected at certain (e.g., set or predetermined) frequency from one or more of the nozzles Z disposed or provided in the first direction DR1. For example, in the example of FIG. 6, in the third inkjet printing process to form or provide the light transmission portion TP and the spacer SPC, twelfth to nineteenth nozzles N12-N19 among the nozzles N may eject the third ink INK3, and the remaining nozzles may not eject the ink. For example, in the third inkjet printing process, the thirteenth to eighteenth nozzles N13-N18 may eject the third ink INK3 into the third color conversion opening CO3 and the spacer opening SO, and the twelfth to nineteenth nozzles N12-N19 may eject the third ink INK3 into the third color conversion opening CO3. FIG. 10 illustrates the thirteenth nozzle N13, representative of the twelfth to nineteenth nozzles N12-N19, which corresponds to the line V-V'.

As illustrated in FIG. 10, during the third inkjet printing process, the position of the inkjet head HD may be fixed and the target substrate may be moved in the second direction DR2, so that (e.g., such that) a position a'-o' of the nozzle (e.g., the thirteenth nozzle N13) relative to the target substrate in the second direction DR2 may vary.

During the third inkjet printing process, the thirteenth to nineteenth nozzles N13-N19 may eject the third ink INK3 if (e.g., when) they are at positions b'-h' which correspond to the third color conversion opening CO3, may eject the third ink INK3 if (e.g., when) they are at positions j'-n' which correspond to the spacer opening SO, and may not eject the third ink INK3 if (e.g., when) they are at positions a', i', and o' which do not correspond to the third color conversion opening CO3 and the spacer opening SO. Herein, the positions b'-h' which correspond to the third color conversion opening CO3 may refer to the positions at which ink ejected from the nozzle may land in the third color conversion opening CO3, and the positions j'-n' which correspond to the spacer opening SO may refer to the positions at which ink ejected from the nozzle may land in the spacer opening SO.

The third inkjet printing process may be performed while reciprocating the target substrate in the second direction DR2 until an appropriate or suitable amount of the third ink INK3 is ejected in the third color conversion opening CO3 and an appropriate or suitable amount of the third ink INK3 is ejected in the spacer opening SO.

In one or more embodiments, in the third color conversion opening CO3, the third ink INK3 may be ejected in an appropriate or suitable amount such that the average thickness of the light transmission portion TP is less than the average thickness of the bank BK (e.g., the second surface is concave in the third direction DR3). In the spacer opening SO, the third ink INK3 may be ejected in an appropriate or suitable amount such that the average thickness of the spacer SPC is greater than the average thickness of the bank BK (e.g., the second surface is convex in the fourth direction DR4).

In one or more embodiments, in the third inkjet printing process, the number of reciprocating movements of the target substrate in the second direction DR2 to form or provide the spacer SPC may be less than or equal to the number of reciprocating movements of the target substrate in the second direction DR2 to form or provide the light transmitting portion TP. For example, compared to a case in which only the light transmission portion TP is formed or provided in the third inkjet printing process, a size of the spacer opening SO may be appropriately or suitably set or predetermined so that (e.g., such that) the number of reciprocating movements of the target substrate in the second direction DR2 does not increase, even if (e.g., when) the spacer SPC is concurrently (e.g., simultaneously) formed or provided with the light transmission portion TP in the third inkjet printing process.

In one or more embodiments, as illustrated in FIGS. 6 and 10, the spacer SPC may be spaced and/or apart (e.g., spaced apart or separated) from the light transmission portion TP in the second direction DR2 by the spacing distance SD. In one or more embodiments, the spacing distance SD may be an integer multiple of the droplet pitch D of the third ink INK3 in the second direction DR2 in the third inkjet printing process. In one or more embodiments, the spacing distance SD may be determined as a value that is greater than or equal to a threshold value and is closest to the threshold value, among values that are integer multiples of the droplet pitch D. For example, if (e.g., when) the droplet pitch D is 3 micrometers and the threshold value is 5 micrometers, the spacing distance SD may be determined as 6 micrometers. However, this is an example and embodiments of the present disclosure are not limited thereto.

In one or more embodiments, as illustrated in FIG. 6, the light transmission portion TP and the spacer SPC may be disposed or provided in a line in the second direction DR2 in plan view. In one or more embodiments, the width W2 of the spacer SPC in the first direction DR1 may be less than or equal to the width W1 of the light transmission portion TP in the first direction DR1.

In one or more embodiments, in the third inkjet printing process, the number of nozzles (e.g., the thirteenth to eighteenth nozzles N13-N18) among the plurality of nozzles N that eject the third ink INK3 into the spacer opening SO to form or provide the spacer SPC may be less than or equal to the number of nozzles (e.g., the twelfth to nineteenth nozzles N12-N19) among the plurality of nozzles N that eject third ink INK3 into the third color conversion opening CO3 to form or provide the light transmission portion TP. For example, it may not be necessary or desired to use additional nozzles to concurrently (e.g., simultaneously) form or provide the spacer SPC with the light transmission portion TP, even compared to a case in which only the light transmission portion TP is formed or provided in the third inkjet printing process. For example, all of the nozzles (e.g., the thirteenth to eighteenth nozzles N13-N18) utilized to form or provide the spacer SPC in the third inkjet printing process may be the nozzles utilized to form or provide the light transmission portion TP. Accordingly, even if (e.g., when) the number of defective nozzles (e.g., nozzles that become unusable due to malfunction) among the nozzles N increases due to a prolonged process, an increase in the process time of the third inkjet printing process may be minimized or reduced. Accordingly, the manufacturing time and manufacturing cost of the color conversion substrate 120 may be reduced.

FIGS. 8 to 10 illustrate that the first color conversion portion CP1, the second color conversion portion CP2, and the light transmission portion TP are sequentially formed or provided, but the order of forming or providing the first color conversion portion CP1, the second color conversion portion CP2, and the light transmission portion TP may be changed. In one or more embodiments, the first to third inkjet printing processes may be performed while the position of the stage is fixed and the inkjet head HD reciprocally moves in the second direction DR2.

In one or more embodiments, each of the first to third inkjet printing processes may be performed while the inkjet head HD is tilted in a first diagonal direction (e.g., a direction between the first direction DR1 and the third direction DR3). In one or more embodiments, each of the first to third inkjet printing processes may be performed while the stage is reciprocally moving in a second diagonal direction (e.g., a direction between the first direction DR1 and the second direction DR2).

After forming or providing the color conversion layer CCL and the spacer SPC, the second protective layer PL2 of FIG. 5 may be formed or provided.

According to one or more embodiments, the spacer SPC is substantially concurrently (e.g., simultaneously) formed or provided with the color conversion layer CCL in the inkjet printing process to form or provide the color conversion layer CCL. For example, the spacer SPC may be substantially concurrently (e.g., simultaneously) formed or provided with the light transmission portion TP in the third inkjet printing process to form or provide the light transmission portion TP. Therefore, a process (e.g., a coating process and a photolithography process) to form or provide the spacer SPC may not be provided. In one or more embodiments, it may not be necessary or desired to utilize additional nozzles to concurrently (e.g., simultaneously) form or provide the spacer SPC with the light transmission portion TP, even compared to a case in which only the light transmission portion TP is formed or provided in the third inkjet printing process. Accordingly, even if (e.g., when) the number of defective nozzles (e.g., nozzles that become unusable due to malfunction) among the nozzles N increases due to a prolonged process, an increase in the process time of the third inkjet printing process may be minimized or reduced. Accordingly, the manufacturing time and manufacturing cost of the color conversion substrate 120 and the display device 100 including the color conversion substrate 120 may be reduced.

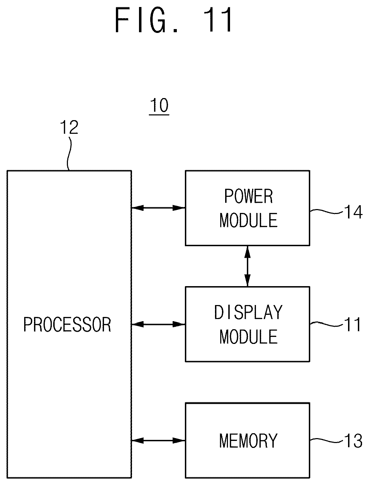

FIG. 11 is a block diagram illustrating an electronic device according to one or more embodiments.

Referring to FIG. 11, an electronic device 10 may include a display module 11, a processor 12, a memory 13, and a power module 14.

A display device according to one or more embodiments may be applied to one or more suitable electronic devices 10.

In one or more embodiments, the electronic device 10 may include the display device 100 of FIGS. 1 to 5. The electronic device 10 may further include modules or devices having additional functions other than the display device.

The processor 12 may include at least one selected from among a central processing unit (CPU), an application processor (AP), a graphic processing unit (GPU), a communication processor (CP), an image signal processor (ISP), and a controller.

The processor may provide an image data signal and/or an input control signal to the display device.

The memory 13 may store data information necessary or desired for the operation of the processor 12 or the display module 11. If (e.g., when) the processor 12 executes the application stored in the memory 13, the image data signal and/or the input control signal may be transmitted to the display module 11, and the display module 11 may process the received signal and output image information through a display screen.

The power module 14 may include a power supply module, such as a power adapter or a battery device, and a power conversion module which converts the power supplied by the power supply module to generate power required or desired for the operation of the electronic device 10.

At least one selected from among each component of the electronic device 10 as described in one or more embodiments may be included in the display device according to one or more embodiments. In one or more embodiments, one or more of the individual modules functionally included in one module may be included in the display device, and other portions may be provided separately from the display device. For example, the display device may include the display module 11, and the processor 12, the memory 13, and the power module 14 may be provided in the form of other devices within the electronic device 10 other than the display device.

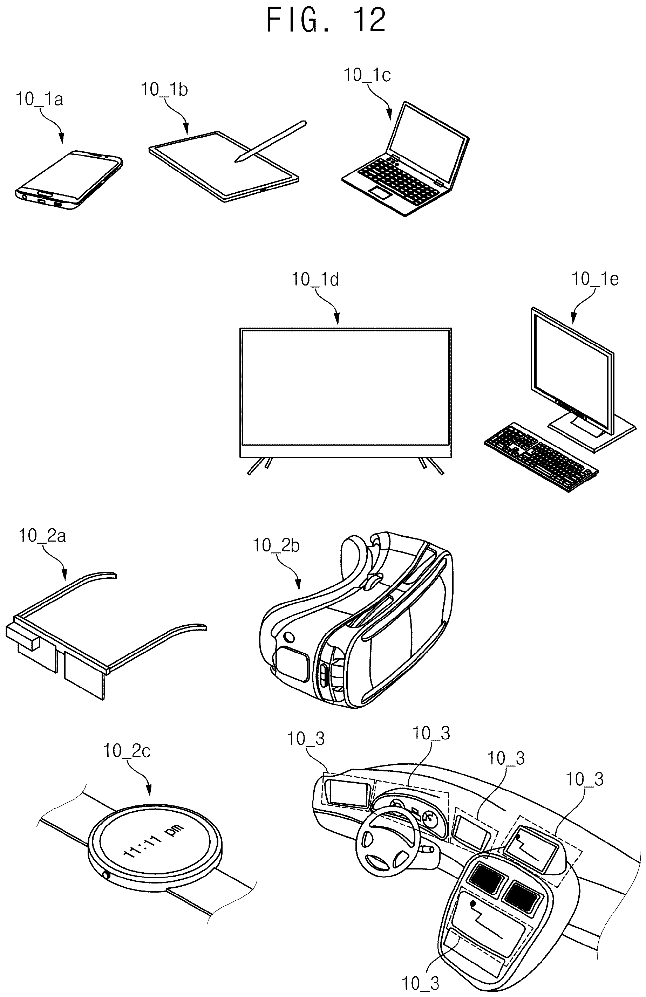

FIG. 12 is a schematic diagram illustrating an electronic device according to one or more embodiments.

Referring to FIGS. 11 and 12, one or more suitable electronic devices 10 to which the display device according to one or more embodiments are applied may include not only image display electronic devices, such as a smartphone 10_1a, a tablet PC 10_1b, a laptop 10_1c, a TV 10_1d, and a desktop monitor 10_1e, but also wearable electronic devices including display modules, such as smart glasses 10_2a, a head-mounted display 10_2b, and a smart watch 10_2c, automotive electronic devices 10_3 including display modules, such as a dashboard of a car, a center fascia, a Center Information Display ("CID") disposed or provided on a dashboard, and a room mirror display, and/or the like.

While the subject matter of the present disclosure has been described in connection with what is presently considered to be practical example embodiments, it is to be understood that the present disclosure is not limited to the disclosed embodiments, but, in one or more embodiments, is intended to cover one or more suitable modifications and equivalent arrangements included within the scope of the appended claims and equivalents thereof. It therefore will be understood that one or more embodiments described herein are just illustrative but not limitative in all aspects.

## Claims

1. A color conversion substrate (120) comprising:
a base layer (BS2) comprising a first emission area (EA1), a second emission area (EA2), and a third emission area (EA3) that are spaced apart from each other in plan view and a non-emission area (NEA) around each of the first emission area (EA1), the second emission area (EA2), and the third emission area (EA3) in plan view;
a bank (BK) provided on the base layer (BS2) and defining a first color conversion opening (CO1), a second color conversion opening (CO2), and a third color conversion opening (CO3) respectively corresponding to the first emission area (EA1), the second emission area (EA2), and the third emission area (EA3) and a spacer opening (SO) provided in the non-emission area (NEA);
a color conversion layer (CCL) provided in the first color conversion opening (CO1), the second color conversion opening (CO2), and the third color conversion opening (CO3); and
a spacer (SPC) provided in the spacer opening (SO) and comprising substantially the same material as the color conversion layer (CCL),
wherein each of the bank (BK) and the spacer (SPC) comprises a first surface (BK-S1, SPC-S1) opposite to the base layer (BS2) and a second surface (BK-S2, SPC-S2) opposite to the first surface (BK-S1, SPC-S1), and
wherein the second surface (SPC-S2) of the spacer (SPC) is convex in a direction (DR4) opposite to a direction (DR3) toward the base layer (BS2) from the second surface (BK-S2) of the bank (BK).

2. The color conversion substrate (120) as claimed in claim 1, wherein the color conversion layer (CCL) comprises:
a first color conversion portion (CP1) provided in the first color conversion opening (CO1) and comprising first color conversion particles that convert blue light into red light;
a second color conversion portion (CP2) provided in the second color conversion opening (CO2) and comprising second color conversion particles that convert blue light into green light; and
a light transmission portion (TP) provided in the third color conversion opening (CO3) and transmitting blue light,
wherein the spacer (SPC) comprises substantially the same material as one selected from among the first color conversion portion (CP1), the second color conversion portion (CP2), and the light transmission portion (TP).

3. The color conversion substrate (120) as claimed in claim 2, wherein the spacer (SPC) comprises substantially the same material as the light transmission portion (TP).

4. The color conversion substrate (120) as claimed in claim 3,
wherein, in plan view, the light transmission portion (TP) and the spacer (SPC) are provided in a first direction (DR1) from the first color conversion portion (CP1) and the second color conversion portion (CP2),
wherein, in plan view, the first color conversion portion (CP1) and the second color conversion portion (CP2) are provided on a first virtual straight line (VL1) extending in a second direction (DR2) substantially perpendicular to the first direction (DR1), and
wherein, in plan view, the light transmission portion (TP) and the spacer (SPC) are provided on a second virtual straight line (VL2) extending in the second direction (DR2) and provided in the first direction (DR1) from the first virtual straight line (VL1).

5. The color conversion substrate (120) as claimed in claim 4,
wherein, in plan view:
(i) a center point (C1) of the first color conversion portion (CP1) and a center point (C2) of the second color conversion portion (CP2) are provided on the first virtual straight line (VL1), and
wherein, in plan view, a center point (C3) of the light transmission portion (TP) and a center point (C4) of the spacer (SPC) are provided on the second virtual straight line (VL2); and/or
(ii) a width (W2) of the spacer (SPC) in the first direction (DR1) is less than or equal to a width (W1) of the light transmission portion (TP) in the first direction (DR1).

6. The color conversion substrate (120) as claimed in any one of claims 2 to 5, wherein:
(i) the color conversion substrate (120) further comprises:
a color filter layer (CFL) provided between the base layer (BS2) and the color conversion layer (CCL) and comprising:
a first color filter (CF1) overlapping the first emission area (EA1) and selectively transmitting red light,
a second color filter (CF2) overlapping the second emission area (EA2) and selectively transmitting green light, and
a third color filter (CF3) overlapping the third emission area (EA3) and selectively transmitting blue light; and/or
(ii) each of the first color conversion portion (CP1), the second color conversion portion (CP2), and the light transmission portion (TP) comprises a first surface (CP1-S1, CP2-S1, TP-S1) opposite to the base layer (BS2) and a second surface (CP1-S2, CP2-S2, TP-S2) opposite to the first surface (CP1-S1, CP2-S1, TP-S1), and
wherein the second surface (CP1-S2, CP2-S2, TP-S2) of each of the first color conversion portion (CP1), the second color conversion portion (CP2), and the light transmission portion (TP) is concave in the direction (DR3) toward the base layer (BS2) from the second surface (BK-S2) of the bank (BK).

7. The color conversion substrate (120) as claimed in any one of claims 1 to 6, wherein:
(i) a thickness of the spacer (SPC) is greater than each of a thickness of the bank (BK) and a thickness of the color conversion layer (CCL); and/or
(ii) the first surface (BK-S1) of the bank (BK) and the first surface (SPC-S1) of the spacer (SPC) are coplanar with each other.

8. A method of manufacturing a color conversion substrate (120), the method comprising:
forming a bank (BK) on a base layer (BS2), the base layer (BS2) comprising a first emission area (EA1), a second emission area (EA2), and a third emission area (EA3) that are spaced apart from each other in plan view, and a non-emission area (NEA) around each of the first emission area (EA1), the second emission area (EA2), and the third emission area (EA3) in plan view, wherein the bank (BK) defines a first color conversion opening (CO1), a second color conversion opening (CO2), and a third color conversion opening (CO3) respectively corresponding to the first emission area (EA1), the second emission area (EA2), and the third emission area (EA3) and a spacer opening (SO) provided in the non-emission area (NEA); and
ejecting an ink into the first color conversion opening (CO1), the second color conversion opening (CO2), and the third color conversion opening (CO3) and the spacer opening (SO) to form a color conversion layer (CCL) in the first color conversion opening (CO1), the second color conversion opening (CO2), and the third color conversion opening (CO3) and a spacer (SPC) in the spacer opening (SO),
wherein each of the bank (BK) and the spacer (SPC) comprises a first surface (BK-S1, SPC-S1) opposite to the base layer (BS2) and a second surface (BK-S2, SPC-S2) opposite to the first surface (BK-S1, SPC-S1), and
wherein the second surface (SPC-S2) of the spacer (SPC) is convex in a direction (DR4) opposite to a direction (DR3) toward the base layer (BS2) from the second surface (BK-S2) of the bank (BK).

9. The method as claimed in claim 8, wherein the forming of the color conversion layer (CCL) and the spacer (SPC) comprises:
ejecting a first ink into the first color conversion opening (CO1) to form a first color conversion portion (CP1), the first ink comprising first color conversion particles that convert blue light into red light;
ejecting a second ink into the second color conversion opening (CO2) to form a second color conversion portion (CP2), the second ink comprising second color conversion particles that convert blue light into green; and
ejecting a third ink into the third conversion opening (CO3) to form a light transmission portion (TP), and
wherein the spacer (SPC) is concurrently formed with one selected from among the first color conversion portion (CP1), the second color conversion portion (CP2), and the light transmission portion (TP).

10. The method as claimed in claim 9, wherein the spacer (SPC) is formed by ejecting the third ink into the spacer opening (SO) concurrently with the forming of the light transmission portion (TP).

11. The method as claimed in claim 10,
wherein, in plan view, the light transmission portion (TP) and the spacer (SPC) are provided in a first direction (DR1) from the first color conversion portion (CP1) and the second color conversion portion (CP2),
wherein, in plan view, the first color conversion portion (CP1) and the second color conversion portion (CP2) are provided on a first virtual straight line (VL1) extending in a second direction (DR2) substantially perpendicular to the first direction (DR1), and
wherein, in plan view, the light transmission portion (TP) and the spacer (SPC) are provided on a second virtual straight line (VL2) extending in the second direction (DR2) and provided in the first direction (DR1) from the first virtual straight line (VL1).

12. The method as claimed in claim 11, wherein, in the forming of the color conversion layer (CCL) and the spacer (SPC), the ink is ejected from one or more of a plurality of nozzles (N) arranged in the first direction (DR1) while moving the base layer (BS2) and the bank (BK) in the second direction (DR2), optionally wherein, in the forming of the color conversion layer (CCL) and the spacer (SPC), the number of nozzles (N) among the plurality of nozzles (N) that eject the third ink into the spacer opening (SO) to form the spacer (SPC) is less than or equal to the number of nozzles (N) among the plurality of nozzles (N) that eject the third ink into the third color conversion opening (CO3) to form the light transmission portion (TP).

13. The method as claimed in claim 12, wherein:
(i) a spacing distance (SD) between the light transmission portion (TP) and the spacer (SPC) in the second direction (DR2) is an integer multiple of a droplet pitch (D) of the ink in the second direction (DR2); and/or
(ii) the number of reciprocating movements of the base layer (BS2) and the bank (BK) in the second direction (DR2) to form the spacer (SPC) is less than or equal to the number of reciprocating movements of the base layer (BS2) and the bank (BK) in the second direction (DR2) to form the light transmission portion (TP).

14. The method as claimed in any one of claims 8 to 13, wherein a thickness of the spacer (SPC) is greater than each of a thickness of the bank (BNK) and a thickness of the color conversion layer (CCL).

15. An electronic device (10) comprising:
a display device (100) comprising:
an array substrate (110) comprising:
a first emission area (EA1), a second emission area (EA2), and a third emission area (EA3) that are spaced apart from each other in plan view;
a non-emission area (NEA) around each of the first emission area (EA1), the second emission area (EA2), and the third emission area (EA3) in plan view; and
a first light emitting element (LED1), a second light emitting element (LED2), and a third light emitting element (LED3) respectively provided in the first emission area (EA1), the second emission area (EA2), and the third emission area (EA3); and
a color conversion substrate (120) on the array substrate (110); and
a processor (12) to transmit an image data signal and an input control signal to the display device (100),
wherein the color conversion substrate (120) comprises:
a base layer (BS2);
a bank (BK) provided on the base layer (BS2) and defining a first color conversion opening (CO1), a second color conversion opening (CO2), and a third color conversion opening (CO3) respectively corresponding to the first emission area (EA1), the second emission area (EA2), and the third emission area (EA3) and a spacer (SPC) opening in the non-emission area (NEA);
a color conversion layer (CCL) in the first color conversion opening (CO1), the second color conversion opening (CO2), and the third color conversion opening (CO3); and
a spacer (SPC) provided in the spacer opening (SO) and comprising substantially the same material as the color conversion layer (CCL),
wherein each of the bank (BK) and the spacer (SPC) comprises a first surface (BK-S1, SPC-S1) opposite to the base layer (BS2) and a second surface (BK-S2, SPC-S2) opposite to the first surface (BK-S1, SPC-S1), and
wherein the second surface (SPC-S2) of the spacer (SPC) is convex in a direction (DR4) opposite to a direction (DR3) toward the base layer (BS2) from the second surface (BK-S2) of the bank (BK).
